Europäisches Patentamt

European Patent Office

Office européen des brevets

(19)

(11) **EP 0 528 784 B1**

## (12) EUROPÄISCHE PATENTSCHRIFT

(45) Veröffentlichungstag und Bekanntmachung des Hinweises auf die Patenterteilung:
**27.01.1999 Patentblatt 1999/04**

(51) Int Cl.$^6$: **G01K 7/20**, G01R 27/14

(21) Anmeldenummer: **92890176.8**

(22) Anmeldetag: **31.07.1992**

(54) **Verfahren zur Bestimmung einer Messgrösse**

Method for the determination of a measurable quantity

Procédé pour la détermination d'une grandeur mesurable

(84) Benannte Vertragsstaaten:
**AT BE CH DE DK ES FR GB GR IT LI LU MC NL PT SE**

(30) Priorität: **16.08.1991 AT 1623/91**

(43) Veröffentlichungstag der Anmeldung:
**24.02.1993 Patentblatt 1993/08**

(73) Patentinhaber:
- **Leopold, Hans, O. Univ.-Prof. Dr.**
  **A-8043 Graz (AT)**
- **Stabinger, Hans, Dr.**
  **A-8042 Graz (AT)**

(72) Erfinder:
- **Leopold, Hans O., Univ.-Prof. Dr.**
  **A-8043 Graz (AT)**
- **Stabinger, Hans, Dr.**
  **A-8042 Graz (AT)**
- **Schröcker, Klaus Peter, Dr.**
  **A-8010 Graz (AT)**

(74) Vertreter: **Gibler, Ferdinand, Dipl.Ing. Dr. techn.**
**Dorotheergasse 7/14**
**1010 Wien (AT)**

(56) Entgegenhaltungen:
**EP-A- 0 120 102          EP-A- 0 173 833**

- **JOURNAL OF PHYSICS E. SCIENTIFIC INSTRUMENTS Bd. 16, Nr. 11, November 1983, BRISTOL GB Seiten 1100 - 1104 H.TAYLOR E.A. 'A MICROCOMPUTER-BASED INSTRUMENT FOR APPLICATIONS IN PLATINUM RESISTANCE THERMOMETRY'**
- **MESSEN + PRUFEN Nr. 9, September 1980, BAD WORISHOFEN DE Seiten 590 - 595 K.W.SCHLENK 'PRAZISE ERFASSUNG QUASISTATISCHER MESSWERTE NACH DEM DOPPELSTROM-MESSVERFAHREN'**
- **PATENT ABSTRACTS OF JAPAN vol. 9, no. 296 (P-407)22. November 1985 & JP-A-60 131 473 ( MATSUSHITA ) 13. Juli 1985**

**Beschreibung**

Die Erfindung betrifft ein Verfahren zur Bestimmung einer als Spannungsabfall an einem Meßwiderstand auftretenden Meßgröße durch Vergleich mit einer als Spannungsabfall an einem Referenzwiderstand auftretenden Referenzgröße, wie z.B. zur Bestimmung des Spannungsabfalles an einem temperaturabhängigen Meßwiderstand durch Vergleich mit dem Spannungsabfall an einem temperaturstabilisierten Referenzwiderstand zum Zwecke der Temperaturmessung, wobei ein positiver Meßstrom in einer ersten Richtung und danach ein negativer Meßstrom in einer zur ersten entgegengesetzten, zweiten Stromrichtung den Meßwiderstand und den Referenzwiderstand durchströmen und dabei vier Spannungsabfälle an den Widerständen gemessen werden, sodann die Differenz der beiden Spannungsabfälle am Meßwiderstand und die Differenz der beiden Spannungsabfälle am Referenzwiderstand und sodann der Quotient dieser beiden Differenzen gebildet wird, der als Maß für die Meßgröße herangezogen wird.

Ferner betrifft die Erfindung eine Schaltungsanordnung zur Durchführung des Verfahrens.

Aus der EP-A 0 120 102 ist ein Thermometer bekannt, das für jede Temperaturmessung vier Spannungsabfälle an insgesamt drei Widerständen, nämlich einem Meß- und zwei Referenzwiderständen, mißt, die Differenz zwischen dem Spannungsabfall am Meßwiderstand und dem am ersten Referenzwiderstand durch die Differenz der Spannungsabfälle am zweiten und ersten Referenzwiderstand teilt und aus diesem Quotienten die Temperatur errechnet. Während durch diese Maßnahme, die allerdings zwei Referenzwiderstände notwendig macht, der Einfluß des Betrages des Meßstromes, Offsetfehler und Steigungsfehler des Meßverstärkers eliminiert werden, bleiben die durch die Thermospannungen in den Meßkreisen und jene durch die Kontaktspannungen von Umschaltern bedingten Fehler bestehen.

In der Druckschrift ".Journal of Physics E: Scientific Instruments Vol.16, Nr. 11, 1983" ist auf den Seiten 1100 bis 1104 ein Platinwiderstandsthermometer geoffenbart, bei welchem die temperaturbedingte Widerstandsänderung eines Meßwiderstandes in bezug auf einen Referenzwiderstand gemessen wird, indem die beiden in Serie geschalteten Widerstände in einem ersten Schritt von einem Strom in einer ersten Richtung und danach in einem zweiten Schritt von einem Strom in einer zur ersten Stromrichtung entgegengesetzten. zweiten Stromrichtung durchströmt werden. Es werden dabei jeweils die Spannungsabfälle am Meß- und Referenzwiderstand gemessen und über Quotientenbildung die Widerstandsverhältnisse errechnet, wobei der einfluß von Thermospannungen und Kontaktwiderständen wegfällt. Das Einprägen der Ströme durch die beiden Widerständc geschieht über einen Operationsverstärker in invertierender Grundschaltung mit denn Meßwiderstand im Gegenkopplungszweig und dem Referenzwiderstand am Eingang, wobei über ein am Referenzwiderstand angelegtes Potential die Höhe und das Vorzeichen des Stromes bestimmt wird. Der Verbindungspunkt zwischen Meß- und Referenzwiderstand liegt über den invertierenden Eingang des Operationsverstärkers virtuell auf Masse.

Aufgabe der Erfindung ist es daher, den Einfluß der Thermospannungen in den Zuleitungen zu den einzelnen Widerständen sowie jenen der Kontaktpotentiale in den Schaltern zu eliminieren und die Meßgenauigkeit zu erhöhen.

Erfindungsgemäß wird dies dadurch erreicht, daß die vier Spannungsabfälle durch die folgenden Schritte ermittelt werden, wobei in jedem Schritt der jeweilige Strom nach Durchströmen des jeweiligen Widerstandes nicht nur virtuell, sondern direkt gegen Masse fließt:

I. der positive Meßstrom nur den Meßwiderstand in der ersten Stromrichtung durchströmt,
II. der negative Meßstrom nur den Meßwiderstand in der zur ersten entgegengesetzten, zweiten Stromrichtung durchströmt,
III. der positive Meßstrom nur den Referenzwiderstand in der ersten Stromrichtung durchströmt,
IV. der negative Meßstrom nur den Referenzwiderstand in der zweiten Stromrichtung durchströmt.

Durch diese Maßnahmen ist es möglich die Offset-Fehler und die Steigungsfehler zu eliminieren, auch wenn die Beträge des positiven und negativen Meßstromes nicht gleich sind. Verbleiben können Linearitätsfehler, die jedoch durch die Verwendung hochwertiger Verstärker bzw. durch Anwendung eines inkrementellen A/D-Umsetzer-Verfahrens hinreichend klein gemacht werden können.

Nach einem weiteren Merkmal der Erfindung kann vorgesehen sein, daß die durch die Meßströme im Meß- bzw. Referenzwiderstand erzeugten Spannungsabfälle jeweils in einen den Spannungsabfällen proportionalen Abbildungsstrom umgewandelt werden.

Durch diese Maßnahme ergibt sich der Vorteil, daß man einen unipolaren A/D-Umsetzer in der Stromdomäne verwenden kann, sodaß ein höherer dynamischer Bereich als in der Spannungsdomäne erzielbar ist.

Weiters kann so vorgegangen werden, daß der Abbildungsstrom in eine Zahl umgewandelt wird, indem nacheinander folgende Verfahrensschritte durchgeführt werden:

a) Integration des Abbildungsstromes während einer vorgegebenen Meßperiode, z.B. 100ms, die unterteilt ist in z.B. 100 Unterperioden, wobei jede unterperiode in z.B. 1000 Taktperioden unterteilt ist, wobei der die Integration vornehmende Integrator vor Beginn der Integration auf einen vorgegebenen ersten Referenzwert gesetzt wird und wobei die Integration zum Zeitpunkt des Beginns einer Taktperiode jeweils beginnt und endet,

b) anschließend - vorzugsweise ab der zweiten Unterperiode - vom Beginn jeder Unterperiode an zusätzlich zum Integral des Abbildungsstromes solange während jeder Unterperiode ein erster Kompensationsstrom integriert wird, welcher einen fest vorgegebenen Wert hat, der dem Betrage nach größer als der größte je auftretende Abbildungsstrom ist und dem Abbildungsstrom entgegengesetzte Polarität aufweist, bis der Wert des Integrals einen fest vorgegebenen zweiten Referenzwert erreicht und die zu diesem Zeitpunkt gehörige Taktperiode beendet ist, wobei die Anzahl der während dieser Integrationen vergangenen Taktperioden über alle Unterperioden aufsummiert wird,

c) nach Ablauf der vorgegebenen Meßperiode Integration nur des ersten Kompensationsstroms bis der Wert des Integrals den zweiten Referenzwert erreicht und die zu diesem Zeitpunkt gehörige Taktperiode beendet ist, wobei die Anzahl der dabei vergangenen Taktperioden zur Summe der aufsummierten Taktperioden addiert wird.

d) Integration nur eines zweiten Kompensationsstromes, der einen genau definierten Bruchteil des ersten Kompensationsstroms ausmacht, solange bis der Wert des Integrals den ersten Referenzwert erreicht und wobei die dafür benötigte Anzahl der Taktperioden - multipliziert mit dem oben angeführten Bruchteil - zur Summe der aufsummierten Taktperioden addiert werden.

Ein weiteres Ziel der Erfindung ist es, eine Schaltungsanordnung zur Durchführung des Verfahrens vorzuschlagen.

Aus dem Artikel "Präzise Erfassung quasistatischer Meßwerte nach dem Doppelstrom-Meßverfahren" Seite 107 ff. der Zeitschrift Messen + Prüfen Nr.9, 1980 ist eine Schaltungsanordnung bekanntgeworden, in welcher mit einem Meß- und einem Referenzwiderstand eine Temperaturmessung vorgenommen wird, indem mit Hilfe zweier Stromquellen und einem Meßstellenumschalter abwechselnd Ströme in den Meß- bzw. Referenzwiderstand eingeprägt und deren Spannungsabfälle abgegriffen und von einem A/D-Wandler umgesetzt werden.

Bei einer Schaltungsanordnung zur Bestimmung einer als Spannungsabfall an einem Meßwiderstand auftretenden Meßgröße durch Vergleich mit einer als Spannungsabfall an einem Referenzwiderstand auftretenden Referenzgröße, mit einer Stromquelle, einer einen Analog/-Digitalumsetzer aufweisenden Auswerteschaltung und einem Meßwiderstand sowie einem in Serie geschalteten Referenzwiderstand, wobei über die Schalter der Meßwiderstand und der Referenzwiderstand mit der Stromquelle bzw. zum wechselweisen Abgriff ihrer Spannungsabfälle mit der Auswerteschaltung verbindbar sind, wobei ein positiver Meßstrom den Meßwiderstand bzw. den Referenzwiderstand in einer ersten Stromrichtung und ein negativer Meßstrom den Meßwiderstand bzw. den Referenzwiderstand in einer zweiten der ersten entgegengesetzten Stromrichtung durchströmt, und wobei die Ansteuerschaltung von einer von einem Taktgeber beaufschlagten Kontroll- und Auswertelogik beaufschlagbar ist, wird gemäß der Erfindung vorgeschlagen, daß der Verbindungspunkt des Meßwiderstandes mit dem Referenzwiderstand nicht nur virtuell, sondern direkt mit Masse verbunden ist, daß eine erste und eine zweite Stromquelle vorgesehen sind, daß die Schalter einen ersten, einen zweiten, einen dritten und einen vierten Schalter umfassen, wobei sich in Geschlossenstellung eines dieser Schalter alle anderen dieser Schalter in Offenstellung befinden, daß die erste Stromquelle über den ersten Schalter mit dem Meßwiderstand verbindbar ist, sodaß in der Geschlossenstellung des ersten Schalters der positive Meßstrom nur den Meßwiderstand in der ersten Stromrichtung durchströmt, daß die zweite Stromquelle über den zweiten Schalter mit dem Meßwiderstand verbindbar ist, sodaß in der Geschlossenstellung des zweiten Schalters der negative Meßstrom nur den Meßwiderstand in der zur ersten entgegengesetzten, zweiten Stromrichtung durchströmt, daß die erste Stromquelle über den dritten Schalter mit dem Referenzwiderstand verbindbar ist, sodaß in der Geschlossenstellung des dritten Schalters der positive Meßstrom nur den Referenzwiderstand in der ersten Stromrichtung durchströmt, daß die zweite Stromquelle über den vierten Schalter mit dem Referenzwiderstand verbindbar ist, sodaß in der Geschlossenstellung des vierten Schalters der negative Meßstrom nur den Referenzwiderstand in der zweiten Stromrichtung durchströmt, und daß die Auswerteschaltung einen aktiven Spannungs/-Stromwandler aufweist und der Analog-Digitalumsetzer für die Eingangsgröße Strom ausgebildet ist.

Auf diese Weise können die Spannungsabfälle über dem Meß- und dem Referenzwiderstand mit Anschluß der Serienschaltung an Stromquellen verschiedener Polarität erfaßt und ausgewertet werden.

Weiters kann vorgesehen sein, daß der Spannungs-/Stromwandler aus zwei Operationsverstärkern aufgebaut ist, wobei beide Operationsverstärker als Spannungsfolger geschaltet sind, deren Eingänge über die Schalter mit dem Meß- bzw. Referenzwiderstand verbindbar sind, deren Ausgänge miteinander über einen Widerstand verbunden sind, wobei der eine Spannungsfolger durch einen Feldeffekttransistor erweitert ist und dieser Spannungsfolger zur Erzeugung eines unipolaren Abbildungsstromes mit einer Stromquelle verbunden ist.

Zufolge dieser Anordnung fließt durch den Widerstand ein der Eingangsspannung des Operationsverstärkers exakt proportionaler Strom. Dabei ist durch den Feldeffekttransistor sichergestellt, daß nicht ein Teil dieses Stromes in den Ausgang des Operationsverstärkers abfließen kann. Außerdem wird durch die vorgeschlagenen Maßnahmen auch verhindert, daß der Ausgangsstrom des Spannungs-/Stromwandlers negativ werden kann, da ein konstanter Offsetstrom zuaddiert wird.

Weiters kann vorgesehen sein, daß der Analog-/Digitalumsetzer einen über einen Kondensator gegengekoppelten Operationsverstärker als Integrator enthält, wobei dem Eingang des Operationsverstärkers über weitere vorzugsweise elektronische Schalter der unipolare Abbildungsstrom sowie der erste und zweite Kompensationsstrom zuführbar sind. und zwei Spannungskomparatoren zur Vorgabe des ersten und zweiten Referenzwertes des Integrals vorgesehen sind.

Durch diese Maßnahmen ist es u.a. möglich die Wärmestromverhältnisse in der Schaltung konstant zu halten.

Ferner ist darauf hinzuweisen, daß sich aus der Maßnahme, daß der A/D-Umsetzer Strom als Signalparameter verwendet, folgende Vorteile ergeben:

1) in der Stromdomäne ist das Verhältnis von oberer Aussteuerungigrenze zum Rauschsignal bei den verfügbaren Operationsverstärkern größer als in der Spannungsdomäne, und

2) das Schalten von Strömen mit einem relativen Fehler von ca $10^{-7}$ (100 pA/1 mA) ist mit handelsüblichen Sperrschicht-Feldeffekttransistoren gut möglich, während Spannungsschalter dieser Fehlerklasse schwer verwirklichbar sind.

Insgesamt kann durch die obigen weiteren Ausgestaltungen der Erfindung wie Spannungs/Stromwandler und A/D-Umsetzer in der Stromdomäne die Genauigkeit der Widerstandsmessung auf besser als 1 ppm gesteigert werden.

Im folgenden ist die Erfindung anhand der Zeichnungen beispielsweise beschrieben.

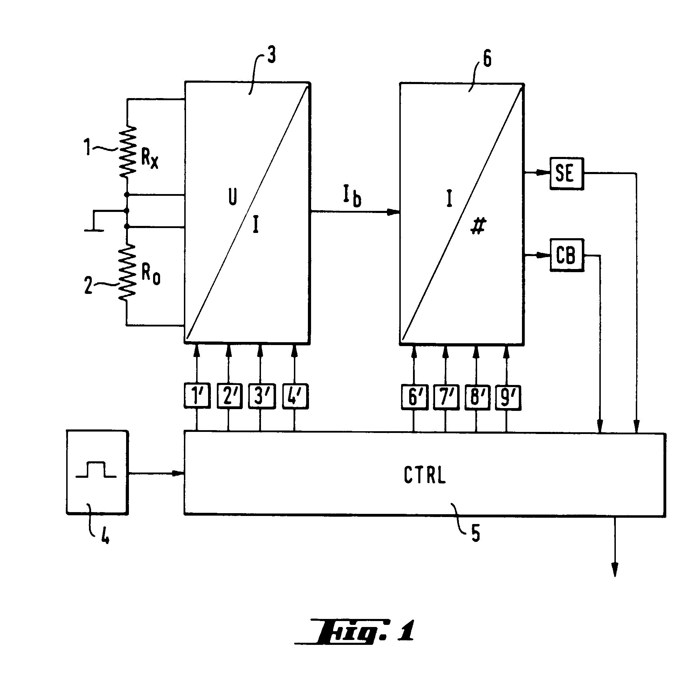

In diesen zeigt Fig. 1 eine Blockdarstellung einer erfindungsgemäßen Meßanordnung,

Fig. 2a einen Spannungs-Stromwandler der Meßanordnung gemäß Fig. 1,

Fig.2b eine Schaltungsanordnung zur Versorgung der Operationsverstärker aus Fig. 2a,

Fig. 3 eine Prinzipdarstellung des Analog/Digital-Umsetzers und

Fig. 4 ein Zeitdiagramm betreffend die Arbeitsweise des Analog/Digital-Umsetzers.

Die Fig.1 zeigt eine Blockdarstellung einer erfindungsgemäßen Schaltungsanordnung zur Temperaturmessung, die Erfindung ist jedoch auf die Temperaturmessung nicht beschränkt, vielmehr kann die Erfindung z.B. auch für die hochgenaue Messung von Widerständen bzw. Widerstandsverhältnisse herangezogen werden kann.

Ein Meßwiderstand ($R_x$) 1 sowie ein Normalwiderstand ($R_o$) 2 sind mittels Vierleiteranschluß mit einem U/I-Wandler 3 verbunden. Die beiden Widerstände werden nacheinander abwechselnd von einem positiven und einem negativen Meßstrom durchströmt und jedesmal wird die an dem jeweiligen Widerstand abfallende Spannung in je einen Abbildungsstrom $I_b$ umgewandelt.

Die dazu erforderlichen vier unterschiedlichen Meßschaltungen werden durch elektronisch steuerbare Schalter hergestellt, welche durch Ansteuersignale 1' bis 4' bzw. non 1' ($\overline{1}'$) bis non 4' ($\overline{4}'$) angesteuert werden. Diese Ansteuersignale werden in einer vom Takt eines Taktgenerators 4 gesteuerten Kontroll- und Auswertelogik 5 erzeugt.

Dem U/I-Wandler 3 nachgeschaltet ist ein Analog/Digital-Umsetzer 6, welcher, gesteuert von weiteren in der Kontroll- und Auswertelogik erzeugten Steuersignalen 6' bis 9' bzw. non 6' ($\overline{6}'$) bis non 8' ($\overline{8}'$), den an seinem Eingang anliegenden Abbildungsstrom $I_b$ umwandelt, wobei am Ausgang zwei Logiksignale SE und CB auftreten, aus deren Zeitverlauf in der Kontroll- und Auswertelogik 5 der Digitalwert des Abbildungsstromes abgeleitet wird. Daraus ist schließlich z.B. der Temperaturwert berechenbar.

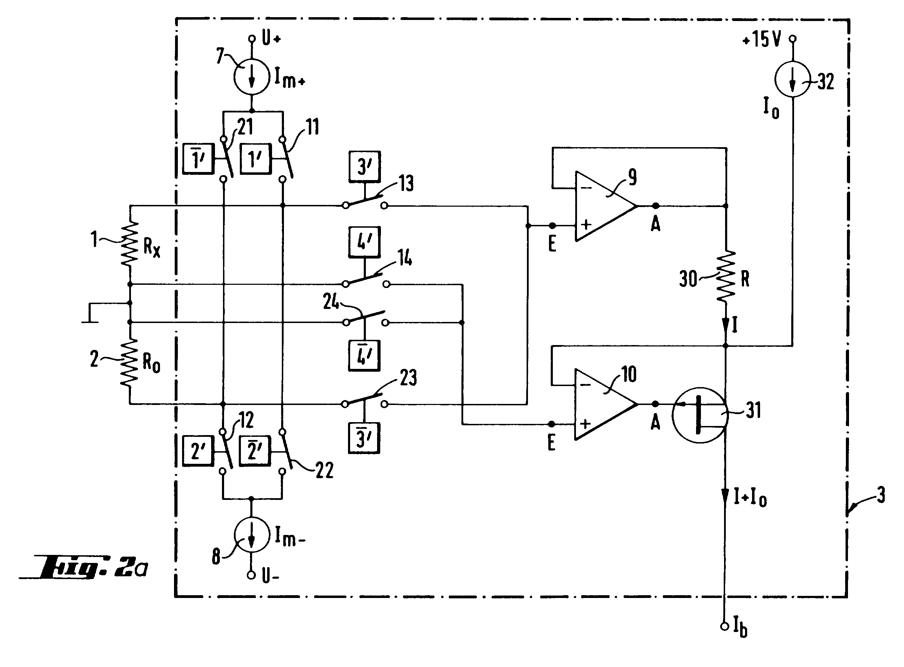

Die Fig. 2a zeigt einen erfindungsgemäßen Spannungs-Strom-Wandler 3.

Der Meßwiderstand ($R_x$) 1 mit getrennten Strom- und Spannungs-Anschlüssen ist mit einem Stromanschluß mit Masse verbunden, der zweite Stromanschluß ist wahlweise entweder über einen ersten elektronisch steuerbaren Schalter 11, der vom Steuersignal 1' gesteuert wird, mit einer ersten Meßstromquelle 7, welche einen positiven Meßstrom $I_{m+}$ liefert und mit einer positiven Versorgungsspannung $U_+$ (z.B. +15V) verbunden ist, verbindbar oder über einen zweiten elektronisch steuerbaren Schalter 22, der vom Steuersignal non 2' ($\overline{2}'$) gesteuert wird, mit einer zweiten Meßstromquelle 8 verbindbar, welche einen Meßstrom $I_{m-}$ zu einer negativen Versorgungsspannung U- (z.B. -30V) abfließen läßt. Vorzugsweise sind die Stromquellen 7,8 so ausgelegt, daß die Beträge der beiden Meßströme $I_{m+}$ und $I_{m-}$ gleich groß sind und beispielsweise 0,5mA betragen. Die Erfindung ist hierauf nicht beschränkt; das erfindungsgemäße Verfahren ist gleichermaßen realisierbar, wenn die Beträge der beiden Meßströme unterschiedlich groß sind.

Ein Referenzwiderstand ($R_o$) 2 mit getrennten Strom- und Spannungsanschlüssen ist mit einem Stromanschluß mit Masse verbunden. Der zweite Stromanschluß ist wahlweise über einen dritten steuerbaren Schalter 21, der vom Steuersignal non 1' ($\overline{1}'$) gesteuert wird, mit der ersten Meßstromquelle 7 bzw. über einen vierten Schalter 12, der vom Steuersignal 2' gesteuert wird, mit der zweiten Meßstromquelle 8 verbindbar.

Als temperaturabhängiger Meßwiderstand 1 wird vorzugsweise ein Widerstand mit genau definierter Widerstands-Temperatur-Kennlinie (wie etwa ein Platinwiderstand) eingesetzt. Da die Temperaturabhängigkeit des Referenzwiderstandes 2 für die Messung störend ist, ist der Referenzwiderstand vorzugsweise in einem Thermostaten eingebaut und mit einem Peltierelement auf konstanter Temperatur gehalten, welche beispielsweise auf etwa 2/10 Grad Celsius genau geregelt wird.

Die Spannungsanschlüsse des Meßwiderstandes 1 sind über je einen steuerbaren Schalter 13 bzw. 14, welche von den Steuersignalen 3' bzw. 4' gesteuert werden, an die Plus-Eingänge zweier Operationsverstärker 9, 10 geführt. Die Spannungsanschlüsse des Referenzwiderstandes 2 sind über zwei weitere steuerbare Schalter 23 bzw. 24, welche von den Steuersignalen non 3' ($\overline{3}$') bzw. non 4' ($\overline{4}$') gesteuert werden, mit denselben Eingängen verbindbar. An den mit dem Minus-Eingang verbundenen Ausgang des als Spannungsfolger geschalteten ersten Operationsverstärkers 9, ist ein Widerstand (R) 30 angeschlossen, dessen zweiter Anschluß mit dem Minus-Eingang des zweiten Operationsverstärkers 10 verbunden ist. Der Ausgang des zweiten Operationsverstärkers 10 ist mit der Gateelektrode eines Feldeffekttransistors 31 verbunden, dessen Source ebenfalls mit dem Widerstand 30 und mit dem invertierenden Eingang des Operationsverstärkers 10 verbunden ist, und dessen Drain den Ausgang des U/I-Wandlers bildet.

Durch die Anordnung der beiden Operationsverstärker als Spannungsfolger tritt die Spannung zwischen den beiden Plus-Eingängen der Operationsverstärker auch am Widerstand 30 auf und es fließt daher durch diesen Widerstand ein dieser Spannung exakt proportionaler Strom I. Damit nicht ein Teil dieses Stroms in den Ausgang des Operationsverstärkers 10 abfließt, ist der FET 31 dazwischengeschaltet. Damit der Ausgangsstrom $I_b = I + I_o$ des U/I-Wandlers auch bei negativem Strom I positiv bleibt, wird ein konstanter Offsetstrom $I_o$ addiert, der in einer Offsetstromquelle 32 erzeugt und in den Knotenpunkt, gebildet aus dem Widerstand 30, dem invertierenden Eingang des Operationsverstärkers 10 und Source des FET 31, eingespeist wird.

Für jede Temperaturmessung werden nacheinander ingesamt vier Spannungsmessungen durchgeführt:

Messung 1:

Die Schalter 11, 13 und 14 werden durch Aktivieren der Steuersignale 1',3' und 4' geschlossen; damit durchströmt der positive Meßstrom $I_{m+}$ den Meßwiderstand 1. Über die Spannungsanschlüsse und die geschlossenen Schalter 13 und 14 wird die an ihm abfallende Spannung an die nicht invertierenden Eingänge der Operationsverstärker 9,10 angelegt, sie tritt damit wieder am Widerstand 30 auf - wird gleichsam auf ihn abgebildet - und erzeugt einen ersten Meßstrom I, der, verschoben um den Offsetstrom $I_o$, am Ausgang als Abbildungsstrom $I_b$ ausgegeben wird. Die bei dieser Messung auftretenden Fehler entsprechen im wesentlichen den Offsetspannungen der Schalter und der Operationsverstärker sowie den Thermospannungen.

Messung 2:

Durch Aktivieren der Steuersignale non 2' ($\overline{2}$'), 3' und 4' wird der Meßwiderstand vom negativen Meßstrom $I_{m-}$ durchströmt und der auftretende Spannungsabfall in einen weiteren, diesmal negativen Meßstrom I umgewandelt und, verschoben um den Offsetstrom wieder als positiver Abbildungsstrom $I_b$ ausgegeben. Die Schalter 13 und 14, die Operationsverstärker sowie die Thermospannungen erzeugen dieselben Offsetfehler wie bei der ersten Messung.

Messung 3:

Durch Aktivieren der Steuersignale non 1' ($\overline{1}$'), non 3' ($\overline{3}$') und non 4' ($\overline{4}$') wird über den geschlossenen Schalter 21 der Referenzwiderstand 2 vom positiven Meßstrom $I_{m+}$ durchflossen und die an ihm abfallende Spannung über die geschlossenen Schalter 23 und 24 an die Operationsverstärker angelegt. Die bei dieser Messung auftretenden Fehler stammen von den Offsetspannungen der Schalter 23 und 24, den beiden Operationsverstärkern sowie den Thermospannungen.

Messung 4:

Schließlich werden die Steuersignale 2', non 3' ($\overline{3}$') und non 4' ($\overline{4}$') angelegt und der Referenzwiderstand 2 damit vom negativen Meßstrom $I_{m-}$ durchflossen. Die bei dieser Messung entstehenden Fehler entsprechen denen der dritten Messung.

Diese vier Messungen werden in der Kontroll- und Auswertelogik 5 ausgewertet, indem jeweils die Differenz zwischen erster und zweiter bzw zwischen dritter und vierter Messung gebildet wird, nämlich:

5

$$I_{m+} \cdot R_x - I_{m-} \cdot R_x \text{ bzw. } I_{m+} \cdot R_o - I_{m-} \cdot R_o.$$

Durch die Differenzbildung werden die Offsetfehler eliminiert. Schließlich wird der Quotient

$$\frac{I_{m+} \cdot R_x - I_{m-} \cdot R_x}{I_{m+} \cdot R_o - I_{m-} \cdot R_o}$$

aus diesen beiden Differenzen gebildet, wodurch auch die Steigungsfehler eliminiert werden.

Um die Genauigkeit des Umsetzers zu erhöhen, kann vorzugsweise vorgesehen sein, daß sowohl der positive Meßstrom $I_{m+}$ wie auch der negative Meßstrom $I_{m-}$ und der Offsetstrom $I_o$ von einer einzigen Stromquelle abgeleitet werden. Schaltungsanordnungen dazu entsprechen dem Stand der Technik und werden etwa für den Entwurf integrierter Operationsverstärker verwendet.

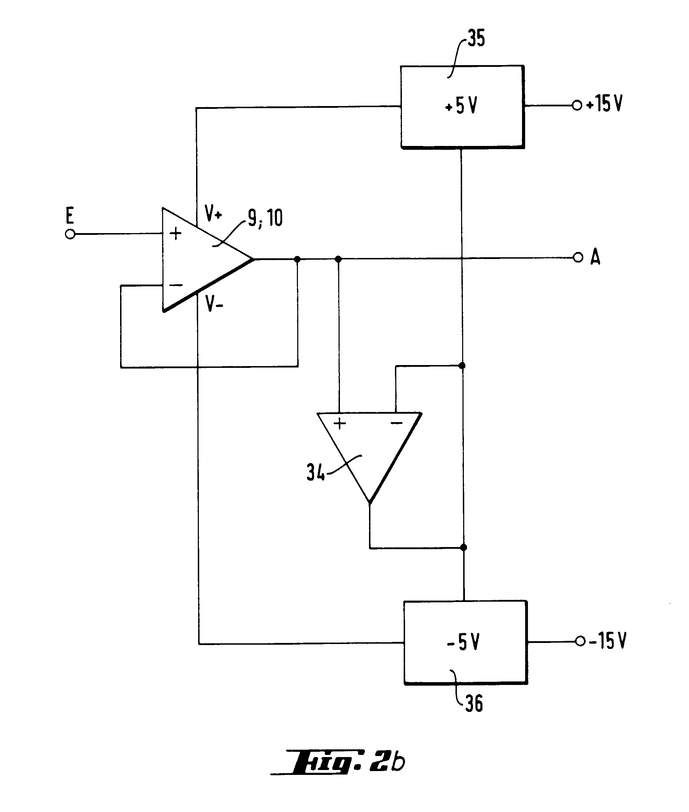

Da die auszuwertenden Spannungsdifferenzen im Bereich von $10^{-7}$V liegen, werden für die beiden Spannungsfolger 9 und 10 hochgenaue Operationsverstärker eingesetzt; außerdem wird durch eine Hilfsschaltung jegliche Gleichtaktaussteuerung vermieden, indem die Operationsverstärker mit auf die Eingangsspannung bezogenen Betriebsspannungen versorgt werden. Für jeden der Operationsverstärker 9, 10 ist eine solche Hilfsschaltung vorgesehen, die Fig. 2b zeigt.

An den Ausgang des hochgenauen Operationsverstärkers 9 bzw. 10, der als Spannungsfolger geschaltet ist, ist der Eingang eines Hilfsspannungsfolgers 34 angeschlossen, dessen Ausgang dem Ausgangspotential des Operationsverstärkers 9 bzw. 10 folgt. An den Ausgang des Hilfsspannungsfolgers sind die Masse-Anschlüsse zweier Spannungsstabilsierungsschaltungen 35,36 angeschlossen, welche an ihren Eingängen mit +15V bzw-15V versorgt werden.

Da die Spannungsstabilisierungsschaltung 35 für eine Ausgangsspannung von +5V ausgelegt ist, tritt an ihrem Ausgang eine Spannung $V_+$ auf, welche um 5V höher als das Potential der Masseanschlüsse und damit um 5V höher als die Ausgangsspannung des hochgenauen Operationsverstärkers 9 bzw. 10 ist und welche an seinen positiven Versorgungsspannungsanschluß geführt wird. Analog dazu wird von der Spannungsstabilisierungsschaltung 36 eine um 5V unter der Ausgangsspannung liegende Spannung $V_-$ als negative Versorgungsspannung für den hochgenauen Operationsverstärker erzeugt. Die in den Fig. 2a und 2b korrespondierenden Eingangs- bzw. Ausgangsklemmen des Operationsverstärkers 9 bzw. 10 sind mit E bzw. A bezeichnet.

Das zweite kritische Bauelement, das neben den Operationsverstärkern die Linearität des U/I-Wandlers bestimmt, ist der Widerstand R. Dieser ist so zu dimensionieren, daß seine Eigenerwärmung nicht störend als stromabhängige Widerstandsänderung in Erscheinung tritt. Er wird dazu möglichst aus mehreren in Serie und parallelgeschalteten Teilwiderständen ausgeführt.

Selbst wenn sich die Nichtlinearität dieses Widerstandes auswirken sollte, bleibt immer noch ein wesentlicher Vorteil des erfindungsgemäßen Konzepts gegenüber den herkömmlichen Lösungen bestehen, nämlich:

es ist nur die Linearität eines einzigen Widerstandes ausschlaggebend, wohingegen bei herkömmlichen Schaltungen, welche Instrumentierungsverstärker verwenden, eine größere Anzahl von Widerständen die Linearität beeinflußt.

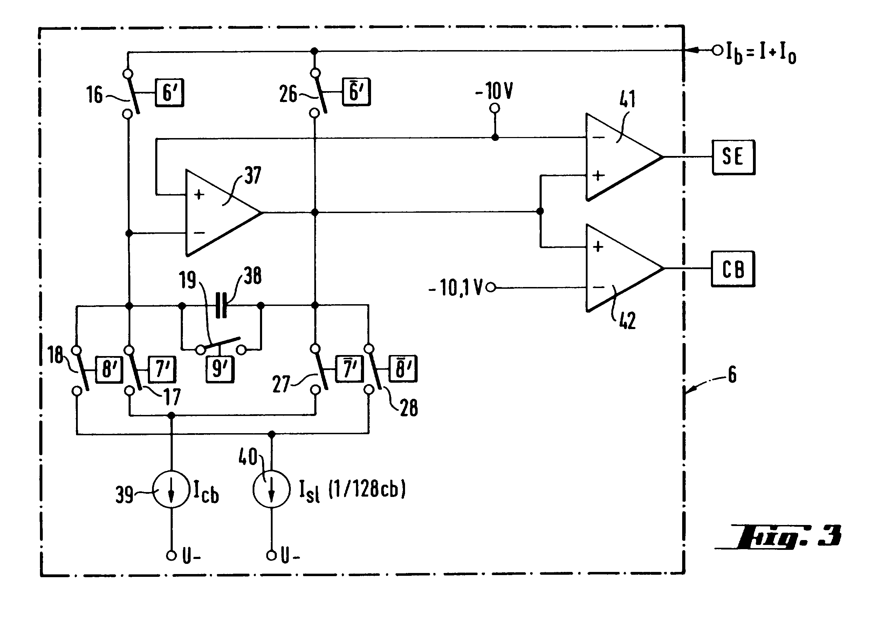

Die Fig. 3 zeigt eine erfindungsgemäße Ausführungsform für den Analog/Digital-Umsetzer 6, welcher gesteuert von den Steuersignalen 6' bis 9' bzw. non 6' ($\overline{6}'$) bis non 8' ($\overline{8}'$) den Eingangsstrom $I_b$ in den quantisierten Zeitverlauf zweier Binärsignale SE und CB und damit in den digitalen Bereich umsetzt.

Es wird wegen des im Vergleich zu Spannungsumsetzern wesentlich größeren Dynamikbereichs ein integrierender A/D-Umsetzer in der Stromdomäne verwendet.

Der Eingangsstrom $I_b$ ist über einen vom Steuersignal 6' gesteuerten Schalter 16 in den Summationspunkt eines Umkehrintegrators einspeisbar, welcher vom Operationsverstärker 37 und dem in den Gegenkopplungszweig eingefügten, über einen von einem Steuersignal 9' gesteuerten Schalter 19 kurzschließbaren Integrationskondensator 38 gebildet wird. Weiters sind von diesem Summationspunkt über einen vom Steuersignal 7' gesteuerten Schalter 17 und über eine Stromquelle 39 ein Kompensationsstrom $I_{cb}$ und weiters über einen vom Steuersignal 8' gesteuerten Schalter 18 und über eine Stromquelle 40 ein Lupenstrom $I_{sl}$ zu einer negativen Versorgungsspannung U- (z. B. -30V) ableitbar.

Um die Wärmestromverhältnisse in der Schaltung konstant zu halten, wird der Abbildungsstrom $I_b$ immer dann, wenn der Schalter 16 offen ist, über einen komplementär zum Schalter 16 angesteuerten Schalter 26 in den Ausgang des Operationsverstärkers 37 eingespeist. Ebenso werden die Kompensationsstromquellen 39 und 40 über komplementär zu den Schaltern 17 und 18 angesteuerte Schalter 27 und 28 mit dem Ausgang des Operationsverstärkers 37 verbunden. Der Pluseingang des Operationsverstärkers und damit der Bezugspunkt des Umkehrintegrators ist mit einer ersten Referenzspannung von -10V verbunden.

Der Ausgang des Operationsverstärkers 37 ist an die Pluseingänge zweier Komparatoren 41 bzw. 42 geführt, an deren Minuseingängen eine Referenzspannung von -10V bzw. von -10, 1V anliegt und welche an ihren Ausgängen die logischen Ausgangssignale SE bzw. CB erzeugen.

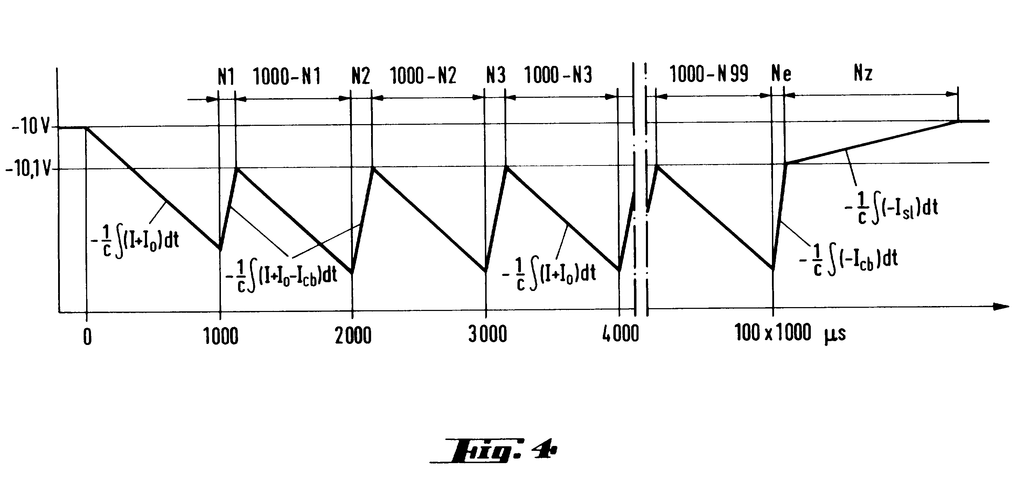

Die Funktionsweise des A/D-Umsetzers 6 wird anhand der Fig.4 beschrieben, welche schematisch den Zeitverlauf der Ausgangsspannung des Integrators während eines vollständigen Umsetzzyklusses zeigt.

Vor Beginn der Umwandlung wird über das Steuersignal 9' der Schalter 19 geschlossen und damit der Integrationskondensator 38 entladen gehalten; damit tritt am Ausgang des Operationsverstärkers dasselbe Potential -10V auf wie am Plus-Eingang.

Während der ersten Unterperiode (von insgesamt 100 solchen Unterperioden für einen kompletten Umwandlungszyklus) sind die Schalter 17,18 und 19 geöffnet, der Schalter 16 ist geschlossen. Der Integrator integriert den Abbildungsstrom $I_b=I+I_o$ und die Ausgangsspannung des Integrators sinkt entsprechend dem angegebenen Integral. Diese Unterperiode dauert in der beschriebenen Ausführung des Umsetzers 1000μs lang, entsprechend 1000 Taktperioden eines zentralen Steuertaktes; vorzugsweise werden alle Schaltvorgänge mit diesem Takt synchronisiert, eine Meßperiode setzt sich aus 100 Unterperioden zusammen.

Die darauffolgenden 99 Unterperioden werden dadurch eingeleitet, daß zusätzlich der Schalter 17 geschlossen wird.

Dies wird durch Aktivieren eines Steuersignals 7' erreicht, das wie auch die anderen Steuersignale in der Kontroll- und Steuerlogik 5 erzeugt und z.B. optoelektronisch oder transformatorgerecht an die Schalter übermittelt wird.

Durch das Schließen des Schalters 17 wird nicht nur der Abbildungsstrom integriert sondern zusätzlich der entgegengerichtete Kompensationsstrom $I_{cb}$. Dadurch steigt die Ausgangsspannung an. Wenn nach N1 Taktperioden (entsprechend N1 μs) die Ausgangsspannung die zweite Referenzspannung -10, 1V erreicht hat, wird dies der Kontroll- und Steuerlogik 5 durch das Ausgangssignal CB über einen optoelektronischen Übertragungsweg mitgeteilt; diese setzt das Steuersignal 7' zurück, wodurch für die Restzeit der Unterperiode der Schalter 17 geöffnet bleibt und die Ausgangsspannung wieder entsprechend dem Integral des Abbildungsstromes absinkt.

Zu Beginn der nächsten Unterperiode wird wieder der Schalter 17 während N2 Taktperioden geschlossen, und sobald der Ausgang die Referenzspannung -10,1V erreicht, ab der nächsten Taktperiode geöffnet. Dies wiederholt sich bis zur hundertsten Unterperiode in der das Teilintervall N99 bestimmt wird.

Nach Ende der letzten Unterperiode wird wieder der Schalter 17 geschlossen, der Schalter 16 jedoch wird geöffnet und nur der Kompensationsstrom $I_{cb}$ wird solange integriert, bis nach Ne Taktperioden die Referenzspannung -10, 1V erreicht ist.

Sobald der Komparator 42 umschaltet und das Ausgangssignal CB erzeugt, wird ab der nächsten Taktperiode die Kompensationsstromquelle durch öffnen des Schalters 17 weggeschaltet und eine Lupenstromquelle $I_{sl}$ durch Schließen des Schalters 18 an den Integrationssummenpunkt gelegt. Damit steigt die Ausgangsspannung des Integrators langsam weiter bis schließlich nach Nz weiteren Taktperioden der Integrationskondensator entladen ist. Der Ausgang hat damit die Referenzspannung-10, 0V erreicht, der Komparator 41 schaltet um und erzeugt das Ausgangssignal SE. Damit ist ein Umsetzzyklus beendet. Bis zu Beginn des nächsten Umsetzzyklus wird der Integrationskondensator durch Schließen des Schalters 19 entladen gehalten.

Stellt man das Ladungsgleichgewicht für den Integrationssummenpunkt während eines kompletten Umsetzzyklus auf, so ergibt sich, wenn N1+N2+...+N99=N gesetzt wird:

$$(I+I_o)*1000 + N*(I+I_o-I_{cb}) + (99*1000-N)*(I+I_o) +$$

$$Ne*(-I_{cb}) + Nz*(-I_{sl})=0$$

oder aufgelöst nach $I+I_o$:

$$(I+I_o) * 100000 = I_{cb} * (N+Ne) +I_{sl} * Nz$$

vorzugsweise wählt man $I_{sl} = I_{cb}/128$, dann ergibt sich

$$(I+I_o) * 100000 = I_{cb} * (N + Ne + Nz/128)$$

oder

$$(I+I_o) * 100000 = I_{sl} * (128*(N+Ne) + Nz).$$

Die Auswertung kann in der Kontroll- und Steuerlogik 5 auf besonders einfache Weise durchgeführt werden, wenn in einem Zähler die einzelnen Ni und dann Ne - alle bewertet mit einem Faktor 128 - und schließlich Nz aufsummiert werden. Der Endzählerstand gibt schließlich das Vielfache des um $I_o$ versetzten Abbildungsstromes $I+I_o$ bezogen auf ein hunderttausendstel des Lupenstromes an.

Durch die Verwendung des Lupenstroms wird die Grundauflösung von 1/100000 noch um mehr als $10^{-2}$ verbessert und so eine solche von $10^{-7}$ erreicht.

Daß im A/D-Umsetzer nur Stromschalter verwendet werden, welche relativ einfach für einen hervorragenden Sperrzustand herstellbar sind, und deren Spannungsfehler den eingeprägten Strom nicht verfälschen, erhöht die praktisch erreichbare Auflösung des A/D-Umsetzers, welche mit Wandlern in der Spannungsdomäne nicht erreichbar ist.

**Patentansprüche**

1. Verfahren zur Bestimmung einer als Spannungsabfall an einem Meßwiderstand (1) auftretenden Meßgröße durch Vergleich mit einer als Spannungsabfall an einem Referenzwiderstand (2) auftretenden Referenzgröße, wie z.B. zur Bestimmung des Spannungsabfalles an einem temperaturabhängigen Meßwiderstand durch Vergleich mit dem Spannungsabfall an einem temperaturstabilisierten Referenzwiderstand zum Zwecke der Temperaturmessung, wobei ein positiver Meßstrom ($I_{m+}$) in einer ersten Richtung und danach ein negativer Meßstrom ($I_{m-}$) in einer zur ersten entgegengesetzten, zweiten Stromrichtung den Meßwiderstand (1) und den Referenzwiderstand (2) durchströmen und dabei vier Spannungsabfälle an den Widerständen (1, 2) gemessen werden, sodann die Differenz der beiden Spannungsabfälle am Meßwiderstand (1) und die Differenz der beiden Spannungsabfälle am Referenzwiderstand (2) und sodann der Quotient dieser beiden Differenzen gebildet wird, der als Maß für die Meßgröße herangezogen wird, **dadurch gekennzeichnet,**
daß die vier Spannungsabfälle durch die folgenden Schritte ermittelt werden, wobei in jedem Schritt der jeweilige Strom nach Durchströmen des jeweiligen Widerstandes nicht nur virtuell, sondern direkt gegen Masse fließt:

   I. der positive Meßstrom ($I_{m+}$) nur den Meßwiderstand (1) in der ersten Stromrichtung durchströmt,
   II. der negative Meßstrom ($1_{m-}$) nur den Meßwiderstand (1) in der zur ersten entgegengesetzten, zweiten Stromrichtung durchströmt,
   III. der positive Meßstrom ($I_{m+}$) nur den Referenzwiderstand (2) in der ersten Stromrichtung durchströmt,
   IV. der negative Meßstrom ($I_{m-}$) nur den Referenzwiderstand (2) in der zweiten Stromrichtung durchströmt.

2. Verfahren nach Anspruch 1, **dadurch gekennzeichnet,** daß die durch die Meßströme im Meß- bzw Referenzwiderstand erzeugten Spannungsabfälle jeweils in einen den Spannungsabfällen proportionalen Abbildungsstrom umgewandelt werden.

3. Verfahren nach Anspruch 2, **dadurch gekennzeichnet,** daß durch Addieren eines Offsetstromes zu dem Abbildungsstrom ein unipolarer Abbildungsstrom erzeugt wird.

4. Verfahren nach Anspruch 2 oder 3, **dadurch gekennzeichnet,** daß der Abbildungsstrom in eine Zahl umgewandelt wird, indem nacheinander folgende Verfahrensschritte durchgeführt werden:

   a) Integration des Abbildungsstromes während einer vorgegebenen Meßperiode, z.B. 100ms, die unterteilt ist in z.B. 100 Unterperioden, wobei jede Unterperiode in z. B. 1000 Taktperioden unterteilt ist, wobei der die Integration vornehmende Integrator vor Beginn der Integration auf einen vorgegebenen ersten Referenzwert gesetzt wird und wobei die Integration zum Zeitpunkt des Beginns einer Taktperiode jeweils beginnt und endet,

   b) anschließend - vorzugsweise ab der zweiten Unterperiode - vom Beginn jeder Unterperiode an zusätzlich zum Integral des Abbildungsstromes solange während jeder Unterperiode ein erster Kompensationsstrom integriert wird, welcher einen fest vorgegebenen Wert hat, der dem Betrage nach größer als der größte je auftretende Abbildungsstrom ist und dem Abbildungsstrom entgegengesetzte Polarität aufweist, bis der Wert des Integrals einen fest vorgegebenen zweiten Referenzwert erreicht und die zu diesem Zeitpunkt gehörige Taktperiode beendet ist, wobei die Anzahl der während dieser Integrationen vergangenen Taktperioden über alle Unterperioden aufsummiert wird,

   c) nach Ablauf der vorgegebenen Meßperiode Integration nur des ersten Kompensationsstroms bis der Wert des Integrals den zweiten Referenzwert erreicht und die zu diesem Zeitpunkt gehörige Taktperiode beendet ist, wobei die Anzahl der dabei vergangenen Taktperioden zur Summe der aufsummierten Taktperioden addiert wird.

d) Integration nur eines zweiten Kompensationsstromes, der einen genau definierten Bruchteil des ersten Kompensationsstroms ausmacht, solange bis der Wert des Integrals den ersten Referenzwert erreicht und wobei die dafür benötigte Anzahl der Taktperioden - multipliziert mit dem oben angeführten Bruchteil - zur Summe der aufsummierten Taktperioden addiert werden.

5. Schaltungsanordnung zur Bestimmung einer als Spannungsabfall an einem Meßwiderstand (1) auftretenden Meßgröße durch Vergleich mit einer als Spannungsabfall an einem Referenzwiderstand (2) auftretenden Referenzgröße, mit einer Stromquelle (7, 8), Schaltern (11, 12, 21, 22, 13, 14, 23, 24), einer einen Analog/-Digitalumsetzer aufweisenden Auswerteschaltung und einem Meßwiderstand (1) sowie einem in Serie geschalteten Referenzwiderstand (2), wobei über die Schalter der Meßwiderstand (1) und der Referenzwiderstand (2) mit der Stromquelle (7, 8) bzw. zum wechselweisen Abgriff ihrer Spannungsabfälle mit der Auswerteschaltung verbindbar sind, wobei ein positiver Meßstrom ($I_{m+}$) den Meßwiderstand (1) bzw. den Referenzwiderstand (2) in einer ersten Stromrichtung und ein negativer Meßstrom ($I_{m-}$) den Meßwiderstand (1) bzw. den Referenzwiderstand (2) in einer zweiten der ersten entgegengesetzten Stromrichtung durchströmt, und wobei die Schalter und der Analog/-Digital umsetzer von einer von einem Taktgeber (4) beaufschlagten Kontroll- und Auswertelogik mit Ansteuersignalen für die Schalter beaufschlagbar sind, **dadurch gekennzeichnet**, daß der Verbindungspunkt des Meßwiderstandes (1) mit dem Referenzwiderstand (2) nicht nur virtuell, sondern direkt mit Masse verbunden ist, daß eine erste und eine zweite Stromquelle (7, 8) vorgesehen sind, daß die Schalter einen ersten (11), einen zweiten (22), einen dritten (21) und einen vierten (12) Schalter umfassen, wobei sich in Geschlossenstellung eines dieser Schalter alle anderen dieser Schalter in Offenstellung befinden. daß die erste Stromquelle (7) über den ersten Schalter (11) mit dem Meßwiderstand (1) verbindbar ist, sodaß in der Geschlossenstellung des ersten Schalters der positive Meßstrom ($I_{m+}$) nur den Meßwiderstand (1) in der ersten Stromrichtung durchströmt, daß die zweite Stromquelle (8) über den zweiten Schalter (22) mit dem Meßwiderstand (1) verbindbar ist. sodaß in der Geschlossenstellung des zweiten Schalters (22) der negative Meßstrom ($I_{m-}$) nur den Meßwiderstand (1) in der zur ersten entgegengesetzten, zweiten Stromrichtung durchströmt, daß die erste Stromquelle (7) über den dritten Schalter (21) mit dem Referenzwiderstand (2) verbindbar ist, sodaß in der Geschlossenstellung des dritten Schalters (21) der positive Meßstrom ($I_{m+}$) nur den Referenzwiderstand (2) in der ersten Stromrichtung durchströmt. daß die zweite Stromquelle (8) über den vierten Schalter (12) mit dem Referenzwiderstand (2) verbindbar ist, sodaß in der Geschlossenstellung des vierten Schalters (12) der negative Meßstrom ($I_{m-}$) nur den Referenzwiderstand (2) in der zweiten Stromrichtung durchströmt, und daß die Auswerteschaltung einen aktiven Spannungs/-Stromwandler (9,10,31,32,33) aufweist und der Analog-Digitalumsetzer (6) für die Eingangsgröße Strom ausgebildet und mit dem Spannungs/-Stromwandler verbunden ist.

6. Schaltungsanordnung nach Anspruch 5, **dadurch gekennzeichnet,** daß der Spannungs-/Stromwandler (3) aus zwei Operationsverstärkern (9, 10) aufgebaut ist, wobei beide Operationsverstärker (9, 10) als Spannungsfolger geschaltet sind, deren Eingänge über die Schalter mit dem Meß- bzw. Referenzwiderstand verbindbar sind, deren Ausgänge miteinander über einen Widerstand (30) verbunden sind, wobei der eine Spannungsfolger (10) durch einen Feldeffekttransistor (31) erweitert ist und dieser Spannungsfolger (10) zur Erzeugung eines unipolaren Abbildungsstromes mit einer Stromquelle (32) verbunden ist.

7. Schaltungsanordnung nach Anspruch 6, **dadurch gekennzeichnet,** daß der Analog-/Digitalumsetzer (6) einen über einen Kondensator (38) gegengekoppelten Operationsverstärker (37) als Integrator enthält, wobei dem Eingang des Operationsverstärkers über weitere vorzugsweise elektronische Schalter (16, 17, 18, 26, 27, 28) der unipolare Abbildungsstrom sowie der erste und zweite Kompensationsstrom zuführbar sind, und zwei Spannungskomparatoren (41, 42) zur Vorgabe des ersten und zweiten Referenzwertes des Integrals vorgesehen sind.

## Claims

1. Method for the determination of a measurable quantity, which occurs as a voltage drop across a measuring resistor (1), by comparison with a reference quantity, which occurs as a voltage drop across a reference resistor (2), such as, for example, for the determination of the voltage drop across a temperature-dependent measuring resistor by comparison with the voltage drop across a temperature-stabilized reference resistor for the purpose of temperature measurement, a positive measurement current ($I_{m+}$) in a first direction and then a negative measurement current ($I_{m-}$) in a second current direction, opposite to the first, flowing through the measuring resistor (1) and the reference resistor (2) and, in the process, four voltage drops across the resistors (1, 2) being measured, and the difference between the two voltage drops across the measuring resistor (1) and the difference between the two voltage drops across the reference resistor (2) being formed, and then the quotient of these two differences being formed, which quotient is used as a measure of the measurable quantity, **characterized**

in that the four voltage drops are determined by the following steps, in each step, after flowing through the respective resistor, the respective current flowing not just virtually but directly to earth:

I. the positive measurement current ($I_{m+}$) only flows through the measuring resistor (1) in the first current direction,

II. the negative measurement current ($I_{m-}$) only flows through the measuring resistor (1) in the second current direction opposite to the first,

III. the positive measurement current ($I_{m+}$) only flows through the reference resistor (2) in the first current direction,

IV. the negative measurement current ($I_{m-}$) only flows through the reference resistor (2) in the second current direction.

2.  Method according to Claim 1, characterized in that the voltage drops generated by the measurement currents in the measuring and reference resistors are each converted into a representational current proportional to the voltage drops.

3.  Method according to Claim 2, characterized in that a unipolar representational current is generated by adding an offset current to the representational current.

4.  Method according to Claim 2 or 3, characterized in that the representational current is converted into a number, by the following method steps being carried out one after the other:

a) integration of the representational current during a predetermined measurement period, for example 100 ms, which is subdivided into, for example, 100 subperiods, each subperiod being subdivided into, for example, 1000 clock periods, the integrator that performs the integration being set to a predetermined, first reference value before the beginning of the integration, and the integration respectively beginning and ending at the instant of the beginning of a clock period,

b) afterwards - preferably starting from the second subperiod - from the beginning of each subperiod on, in addition to the integral of the representational current, a first compensation current, which has a fixedly predetermined value whose magnitude is greater than the largest representational current occurring in each case and whose polarity is opposite to that of the representational current, is integrated during each subperiod until the value of the integral reaches a fixedly predetermined, second reference value and the clock period associated with this instant has ended, the number of clock periods that have elapsed during these integrations being summed over all the subperiods,

c) after the expiry of the predetermined measurement period, integration only of the first compensation current until the value of the integral reaches the second reference value and the clock period associated with this instant has ended, the number of clock periods that have elapsed in the process being added to the sum of the summed clock periods,

d) integration only of a second compensation current, which makes up an exactly defined fraction of the first compensation current, until the value of the integral reaches the first reference value, the requisite number of clock periods - multiplied by the abovementioned fraction - being added to the sum of the summed clock periods.

5.  Circuit arrangement for the determination of a measurable quantity, which occurs as a voltage drop across a measuring resistor (1), by comparison with a reference quantity, which occurs as a voltage drop across a reference resistor (2), having a current source (7, 8), switches (11, 12, 21, 22, 13, 14, 23, 24), an evaluation circuit, which has an analogue/digital converter, and a measuring resistor (1) as well as a reference resistor (2) connected in series, it being possible to connect the measuring resistor (1) and the reference resistor (2) via the switches to the current source (7, 8) and/or, for the purpose of alternately tapping their voltage drops, to the evaluation circuit, a positive measurement current ($I_{m+}$) flowing through the measuring resistor (1) and/or the reference resistor (2) in a first current direction and a negative measurement current ($I_{m-}$) flowing through the measuring resistor (1) and/or the reference resistor (2) in a second current direction, which is opposite to the first, and it being possible for driving signals for the switches to be applied to the switches and the analogue/digital converter by a control and evaluation logic arrangement acted upon by a clock generator (4), **characterized** in that the junction point between the measuring resistor (1) and the reference resistor (2) is connected not just virtually but directly to earth, in that a first and a second current source (7, 8) are provided, in that the switches comprise a first (11), a second (22), a third (21) and a fourth (12) switch, when one of these switches is in the closed position all of the others being in the open position, in that the first current source (7) can be connected via the first switch (11) to the measuring resistor (1), with the result that in the closed position of the first switch, the positive measurement current ($I_{m+}$) only flows through the measuring resistor (1) in the first current direction, in that the second current source (8) can be connected via the second switch (22) to the measuring resistor (1), with the result that in the closed position of the second switch (22), the negative measurement current ($I_{m-}$) only flows through the measuring resistor (1) in the second current direction opposite to the first, in that the first current source (7) can be connected via the third switch (21) to the reference resistor (2), with the result that in the closed position of the third switch (21), the positive measurement current ($I_{m+}$) only flows through the reference resistor (2) in the first current direction, in that the second current source (8) can be connected via the fourth switch (12) to the reference resistor (2), with the result that in the closed position of the fourth switch (12), the negative measurement current ($I_{m-}$) only flows through the reference resistor (2) in the second current direction, and in that the evaluation circuit has an active voltage/current converter (9, 10, 31, 32, 33) and the analogue-digital converter (6) is designed for the input quantity of current and is connected to the voltage/current converter.

6. Circuit arrangement according to Claim 5, **characterized** in that the voltage/current converter (3) is constructed from two operational amplifiers (9, 10), the two operational amplifiers (9, 10) being connected as voltage followers whose inputs can be connected via the switches to the measuring and/or reference resistors, whose outputs are connected to one another via a resistor (30), one voltage follower (10) being augmented by a field-effect transistor (31) and this voltage follower (10) being connected to a current source (32) for the purpose of generating a unipolar representational current.

7. Circuit arrangement according to Claim 6, **characterized** in that the analogue/digital converter (6) contains, as integrator, an operational amplifier (37) having negative feedback via a capacitor (38), it being possible to feed the unipolar representational current and also the first and second compensation currents to the input of the operational amplifier via further, preferably electronic switches (16, 17, 18, 26, 27, 28), and two voltage comparitors (41, 42) for the specification of the first and second reference values of the integral are provided.

## Revendications

1. Procédé pour la détermination d'une grandeur à mesurer constituée par une chute de tension existant aux bornes d'une résistance de mesure (1), par comparaison avec une grandeur de référence constituée par une chute de tension existant aux bornes d'une résistance de référence (2), comme, par exemple, pour déterminer la chute de tension aux bornes d'une résistance variable avec la température par comparaison avec la chute de tension aux bornes d'une résistance de référence stable à la température dans le but de mesurer une température, dans lequel un courant de mesure positif ($I_{m+}$) traverse, dans un premier sens de courant, la résistance de mesure (1) et la résistance de référence (2) et ensuite un courant de mesure négatif ($I_{m-}$) les traverse dans un deuxième sens de courant opposé au premier et on mesure alors quatre chutes de tension aux bornes des résistances (1, 2) et on forme ensuite la différence des deux chutes de tension aux bornes de la résistance de mesure (1) et la différence des deux chutes de tension aux bornes de la résistance de référence (2) et ensuite le quotient de ces deux différences qui est extrait en tant que mesure pour la grandeur à mesurer,
**caractérisé en ce que**
    les quatre chutes de tension sont obtenues par les étapes suivantes, le courant respectif circulant, dans chaque étape, après avoir traversé la résistance correspondante, non seulement virtuellement, mais directement, à la masse :

    I. le courant de mesure positif ($I_{m+}$) ne traverse la résistance de mesure (1) que dans le premier sens de courant,
    II; le courant de mesure négatif ($I_{m-}$) ne traverse la résistance de mesure (1) que dans le deuxième sens de courant opposé au premier,
    III. le courant de mesure positif ($I_{m+}$) ne traverse la résistance de référence (2) que dans le premier sens de courant,
    IV. le courant de mesure négatif ($I_{m-}$) ne traverse la résistance de référence (2) que dans le deuxième sens de courant.

2. Procédé selon la revendication 1, caractérisé en ce que les chutes de tension fournies par les courants de mesure dans la résistance de mesure, respectivement dans la résistance de référence, sont, à chaque fois, transformées en un courant image proportionnel aux chutes de tension.

3. Procédé selon la revendication 2, caractérisé en ce que, par addition d'un courant de décalage au courant image, on produit un courant image unipolaire.

4. Procédé selon la revendication 2 ou 3, caractérisé en ce que le courant image est transformé en un nombre en réalisant successivement les étapes suivantes :

   a) intégration du courant image pendant une période de mesure prédéterminée, par exemple 100 ms, qui est divisée en, par exemple, 100 sous-périodes, chaque sous-période étant divisée en 1000 périodes d'horloge, l'intégrateur réalisant l'intégration étant réglé, avant le début de l'intégration, à une première valeur de référence prédéterminée et l'intégration commençant et finissant à chaque fois à l'instant du début d'une période d'horloge,

   b) ensuite - de préférence à partir de la deuxième sous-période - à partir du début de chaque sous-période, en plus de l'intégrale du courant image, on intègre, pendant chaque sous-période, un premier courant de compensation qui a une valeur fixe prédéterminée qui, en fonction du montant, est plus grande que le plus grand courant image se produisant à chaque fois et présente une polarité inverse à celle du courant image, jusqu'à ce que la valeur de l'intégrale atteigne une deuxième valeur de référence prédéterminée et que la période d'horloge correspondant à cet instant soit terminée, le nombre des périodes d'horloge passées pendant ces intégrations étant additionné pour toutes les sous-périodes,

   c) après l'écoulement de la période de mesure prédéterminée, intégration de seulement le premier courant de compensation jusqu'à ce que la valeur de l'intégrale atteigne la deuxième valeur de référence et que la période d'horloge correspondant à cet instant soit terminée, le nombre des périodes d'horloge passées pendant ce temps étant additionné à la somme des périodes d'horloge additionnées,

   d) Intégration seulement d'un deuxième courant de compensation qui constitue une fraction définie de manière précise du premier courant de compensation jusqu'à ce que la valeur de l'intégrale atteigne la première valeur de référence, le nombre des périodes d'horloge nécessitées pour cela - multiplié avec la fraction précitée - étant additionné à la somme des périodes d'horloge additionnées.

5. Dispositif de circuit pour la détermination d'une grandeur à mesurer constituée par une chute de tension existant aux bornes d'une résistance de mesure (1), par comparaison avec une grandeur de référence constituée par une chute de tension existant aux bornes d'une résistance de référence (2), comportant une source de courant (7, 8), des commutateurs (11, 12, 21, 22, 13, 14, 23, 24), un circuit d'évaluation comportant un convertisseur analogique-numérique et une résistance de mesure (1) ainsi qu'une résistance de référence (2) branchée en série, dans lequel la résistance de mesure (1) et la résistance de référence (2) peuvent être reliés, par l'intermédiaire des commutateurs, à la source de courant (7, 8), respectivement au circuit d'évaluation pour le prélèvement en alternance de leurs chutes de tension. dans lequel un courant de mesure positif ($I_{m+}$) traverse la résistance de mesure (1), respectivement la résistance de référence (2), dans un premier sens de courant et un courant de mesure négatif ($I_{m-}$) traverse la résistance de mesure (1), respectivement la résistance de référence (2), dans un deuxième sens de courant opposé au premier et dans lequel les commutateurs et le convertisseur analogique-numérique peuvent être commandés par une logique de contrôle et d'évaluation commandée par une horloge (4) et fournissant des signaux de commande pour les commutateurs, **caractérisé en ce que** le point commun à la résistance de mesure (1) et à la résistance de référence (2) est relié, non seulement de manière virtuelle, mais directement, à la masse, en ce que l'on prévoit une première et une deuxième sources de courant (7, 8), en ce que les commutateurs comprennent un premier (11), un deuxième (22), un troisième (21) et un quatrième (12) commutateurs, tous les autres de ces commutateurs étant en position d'ouverture lorsque l'un d'entre eux est en position de fermeture, en ce que la première source de courant (7) peut être reliée à la résistance de mesure (1) par l'intermédiaire du premier commutateur (11) de telle sorte que, pour la position de fermeture du premier commutateur (11), le courant de mesure positif ($I_{m+}$) ne traverse que la résistance de mesure (1) dans le premier sens de courant, en ce que la deuxième source de courant (8) peut être reliée à la résistance de mesure (1) par l'intermédiaire du deuxième commutateur (22) de telle sorte que, pour la position de fermeture du deuxième commutateur (22), le courant de mesure négatif ($I_{m-}$) ne traverse que la résistance de mesure (1) dans le deuxième sens de courant opposé au premier, en ce que la première source de courant (7) peut être reliée à la résistance de référence (2) par l'intermédiaire du troisième commutateur (21) de telle manière que, dans la position de fermeture du troisième commutateur (21), le courant de mesure positif ($I_{m+}$) ne traverse que la résistance de référence (2) dans le premier sens de courant, en ce que la deuxième source de courant (8) peut être reliée à la résistance de référence (2) par l'intermédiaire du quatrième commutateur (12) de telle manière que, dans la position de fermeture du quatrième commutateur (12), le courant de mesure positif ($I_{m+}$) ne traverse que la résistance de référence (2) dans le deuxième sens de courant et en ce que le circuit d'évaluation comprend un transformateur actif de courant en tension (9, 10, 31, 32, 33) et que le convertisseur analogique-numérique (6) est conformé en courant pour la grandeur d'entrée et est relié au transformateur de courant en tension.

6. Dispositif de circuit selon la revendication 5, **caractérisé en ce que** le transformateur de courant en tension (3) est réalisé au moyen de deux amplificateurs opérationnels (9, 10), les deux amplificateurs opérationnels (9, 10) étant branchés en étage suiveur de tension dont les entrées peuvent être reliées, par l'intermédiaire des commutateurs, à la résistance de mesure, respectivement à la résistance de référence, dont les sorties sont reliées entre elles par une résistance (30), l'un des suiveurs de tension (10) étant complété par un transistor à effet de champ (31) et ce suiveur de tension (10) étant relié à une source de courant (32) pour produire un courant image unipolaire.

7. Dispositif de circuit selon la revendication 6, **caractérisé en ce que** le convertisseur analogique-numérique (6) comprend un amplificateur opérationnel (37) découplé au moyen d'un condensateur (38) et constituant un intégrateur, le courant image unipolaire ainsi que le premier et le deuxième courants de compensation pouvant être envoyés sur l'entrée de l'amplificateur opérationnel au moyen d'autres commutateurs, de préférence électroniques (16, 17, 18, 26, 27, 28), et que l'on prévoit deux comparateurs de tension (41, 42) pour fournir la première et la deuxième valeurs de référence de l'intégrale.

*Fig. 1*

Fig. 2a

EP 0 528 784 B1

*Fig. 2b*

Fig. 3

EP 0 528 784 B1

Fig. 4

EP 0 528 784 B1